# EUROPEAN PATENT APPLICATION

(11) **EP 4 435 535 A1**
(43) Date of publication of application: **25.09.2024**
(21) Application number: 24163802.2
(22) Date of filing: 15.03.2024
(51) Int. Cl.: G04C 10/02, H01L 31/02, H01L 31/05

(54) **ELECTRONIC TIMEPIECE INCLUDING A SOLAR PANEL AND MANUFACTURING METHOD THEREOF**

(30) Priority: 24.03.2023 JP 2023048224
(71) Applicant: Casio Computer Co., Ltd., Tokyo 151-8543 (JP)
(72) Inventor: SAITO, Yuta, Tokyo, 205-8555 (JP)
(74) Representative: Plougmann Vingtoft a/s

(57) **Abstract**

Disclosed is an electronic device (1) including: a solar cell (71) including a power generation layer (712) and a pair of electrodes (711, 713) that sandwich the power generation layer; and a coat (75) that has a second face (75P) attached to at least part of a first face (71P) of the solar cell. The coat includes extraction wirings (752) that are located on the second face and electrically connected to the electrodes.

## Description

### TECHNICAL FIELD

The present disclosure relates to an electronic device, an electronic timepiece, and a manufacturing method of a solar panel.

### DESCRIPTION OF RELATED ART

Electronic devices including solar cells can store power generated by the solar cells and operate continuously for a long time. In the electronic devices, power is supplied to batteries or other devices via take-out wirings that connect to the electrodes of the solar cells.

Since structures that take out power in small electronic devices are prone to breakage or disconnection and have durability problems, a structure that reliably takes out power is disclosed in JP 200976560 A and JP H07287081 A.

### SUMMARY OF THE INVENTION

However, conventional structures tend to be custom-made according to the shape and size of electronic devices, which increases the time and cost involved in design development and manufacturing, respectively.

A purpose of the present disclosure is to provide an electronic device, an electronic timepiece, and a manufacturing method of a solar panel that can output power generated by a solar cell more simply and flexibly.

According to an aspect of the present disclosure, there is provided an electronic device (1) including: a solar cell (71) including a power generation layer (712) and a pair of electrodes (711, 713) that sandwich the power generation layer; and a coat (75) that has a second face (75P) attached to at least part of a first face (71P) of the solar cell, wherein the coat includes extraction wirings (752) that are located on the second face and electrically connected to the electrodes.

According to an aspect of the present disclosure, there is an effect of providing a solar panel that can output power generated by a solar cell in a simpler and more flexible manner.

### BRIEF DESCRIPTION OF DRAWINGS

The accompanying drawings are not intended as a definition of the limits of the invention but illustrate embodiments of the invention, and together with the general description given above and the detailed description of the embodiments given below, serve to explain the principles of the invention, wherein:
FIG. 1 is a plan view of an electronic timepiece of a first embodiment;
FIG. 2A is a plan view of a solar panel;
FIG. 2B is a cross-sectional view of the solar panel;
FIG. 2C is a cross-sectional view of the solar panel;
FIG. 3A shows solar cells and a base of the solar panel;
FIG. 3B shows a laminate film of the solar panel;
FIG. 4 is a plan view of an electronic timepiece of a second embodiment;
FIG. 5A illustrates the panel arrangement of a solar panel of the second embodiment;
FIG. 5B is a cross-sectional view of the solar panel of the second embodiment;
FIG. 6A is a plan view of solar cells and a base in the solar panel of the second embodiment;
FIG. 6B shows a laminate film of the solar panel of the second embodiment; and
FIG. 7 shows another example of a solar panel structure of the first embodiment.

### DETAILED DESCRIPTION

Embodiments are described below based on the drawings.

### (First Embodiment)

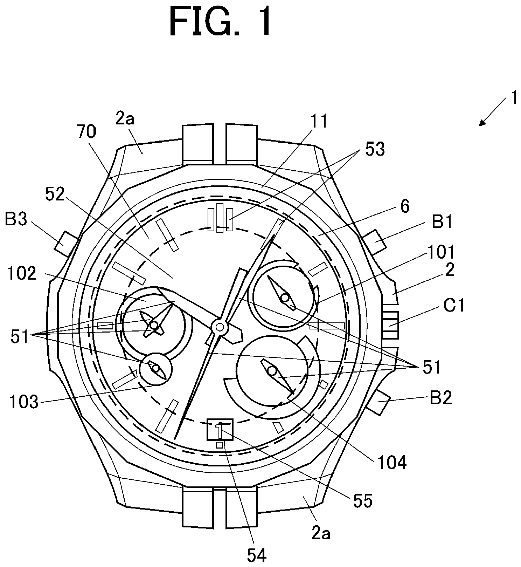

FIG. 1 is a plan view of an electronic timepiece 1 of a first embodiment.

The electronic timepiece 1, which is an electronic device of the present embodiment, has a housing 2, a dial 52, hands 51, a bezel 11, and operation receivers that receive external operations such as pushbutton switches B1 to B3 and a crown C1. On the dial 52, the hands 51 are located so as to be rotatable, and the contents are displayed according to the direction in which each hand 51 points. The contents displayed by the hands 51 include the time (or date and time including date, day of the week, and the like). On the dial 52, signs (hour marks 53) and the like are located to indicate the displayed time.

On the dial 52 are located small windows 101 to 104 (sub-dials), each occupying part (of the display surface) of the dial 52. Some of the hands 51 (small hands) are rotatable inside each of these small windows 101 to 104 to display the day of the week, alarm setting time, time in other cities of the world (including UTC), and 24-hour time.

The dial 52 has an opening 54 in the 6 o'clock direction. A date wheel 55 is located below (on the back side) of the dial 52. The date wheel 55 has display of circularly arranged numerals (date signs) corresponding to the dates. Rotation of the date wheel 55 selectively displays one of the date signs through the opening 54. The portion of the date wheel 55 other than the date signs is permeable to light, except for the frame-shaped portion necessary to support and rotate and move said date signs.

The housing 2 has a cylindrical shape with the top and bottom surfaces open. The housing 2 houses the above-mentioned hands 51, date wheel 55, dial 52, and hour marks 53, as well as a circuit board including the control unit, the drive unit, and the battery. The control unit controls the timekeeping operation and the display operation by the hands 51. The drive unit includes stepping motors and gear trains, which rotate the hands 51 and the date wheel 55 to change their pointing positions. The pushbutton switches B1 to B3 and the crown C1 project outward at the sides of the housing 2. The electrical signals for these operations are transmitted to the circuit board inside the housing 2. In the 12 o'clock and 6 o'clock directions of the housing 2, the belt attachment portion 2a extends outward from the housing 2 in plan view. The housing 2 may be an insulating material such as resin or ceramic, or a metal member such as titanium. The lower end (rear side) of the housing 2 is sealed by the back cover, which is not shown.

The upper part of the dial 52 and the hands 51 (upper end of the housing 2, front surface side) is covered by a transparent windshield member, not shown in the figure, which seals the housing 2. The periphery of the dial 52 is enclosed by the parting plate 6. Some or all of the hour marks 53 and the like may be fixed to the parting plate 6.

The windshield member, for example, is fitted along the inner edge of the housing 2 and is surrounded in plan view by a bezel 11. This bezel 11 may have a sign pointed by the hand 51. The bezel 11 may also have a shock-resistant structure and may also be used for decorative purposes. Furthermore, the bezel 11 may function as an antenna element when the electronic timepiece 1 is receiving radio waves or communicating.

Below the dial 52, a solar panel 70 is located annularly (between the concentric dashed lines in FIG. 1) along the inner edge of the parting plate 6. At least above the solar panel 70 (in the second range) of the dial 52 is a member with light permeability. This member with light permeability may be made of a material such that the solar panel 70 is not directly visible through said member with light permeability.

The above battery is a rechargeable battery, which is charged by the power generated by the solar panel 70 to supply the power to the control and drive units, and the like for operation.

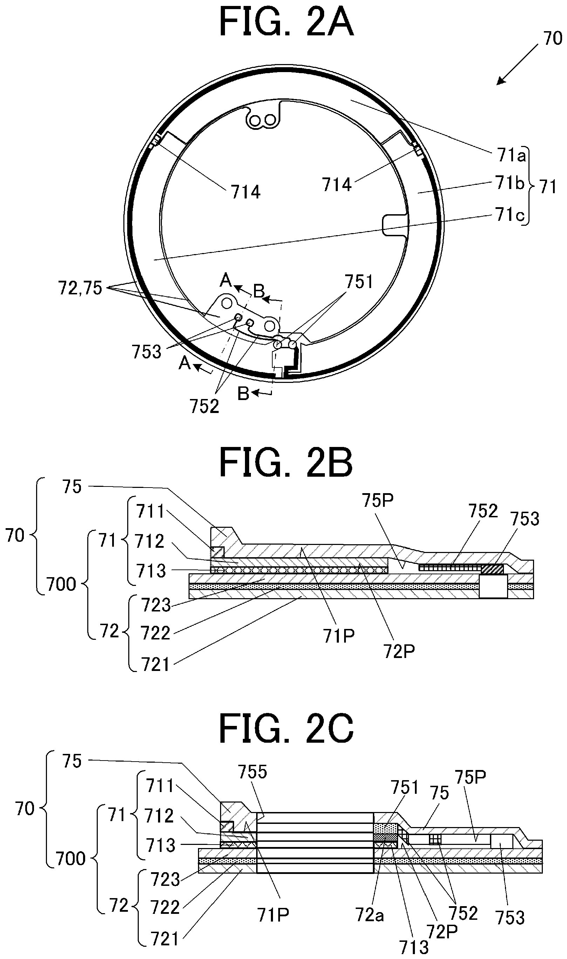

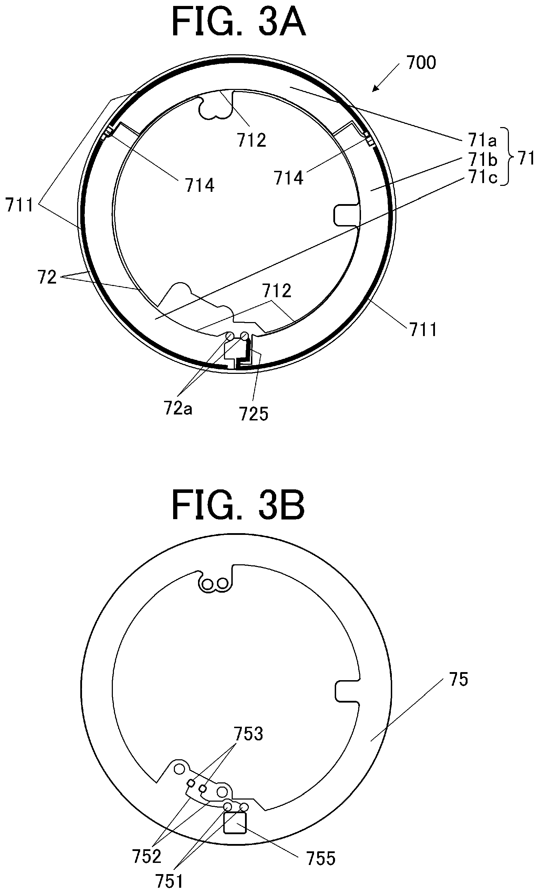

FIGS. 2A to 2C and FIGS. 3A to 3B illustrate the structure of the solar panel 70 in the electronic timepiece 1.

FIG. 2A is a plan view of the solar panel 70. FIG. 2B is a cross-sectional view at the section line AA. FIG. 2C is a cross-sectional view at the section line BB. FIG. 3A is a view showing solar cells 71 (solar cells) and a base 72 of the solar panel 70. FIG. 3B is a view showing a laminate film 75.

The solar panel 70 has three solar cells 71a to 71c (also collectively described as solar cells 71), a base 72, and a laminate film 75. As shown in FIG. 2A and FIG. 3A, the solar cells 71a to 71c have an arcuate shape and are arranged in an overall substantially annular shape. The solar cells 71 are located on one side (third face 72P) of the base 72, which is slightly wider than the solar cells 71 in plan view. The solar cells 71 and the base 72 constitute the structure 700. On the side of a wiring electrode 711 (side of the first face 71P) in the solar cell 71 of the structure 700, the laminate film 75 of approximately the same size and shape as the base 72 is bonded at least in part.

The solar cell 71 has a planar lower electrode 713, a power generation layer 712 on the lower electrode 713, and the wiring electrode 711 on the power generation layer 712. In other words, the power generation layer 712 is positioned sandwiched by a pair of electrodes consisting of the lower electrode 713 and the wiring electrode 711. The power generation layer 712 outputs a power generation electromotive force in response to incidence light between the pair of electrodes. The first face 71P on the side of the wiring electrode 711 of the power generation layer 712 is the light incidence surface. The wiring electrodes 711 of the respective solar cells 71 extend in a concentric circular line along the outer edge of the solar cells 71 arranged in a substantially annular shape. The wiring electrode 711 is a fine line, thereby reducing the range where light incidence to the power generation layer 712 is blocked by the wiring electrode 711. The wiring electrode 711 may be an electrode having light permeability, particularly a transparent electrode.

The solar cells 71a to 71c are connected in series. In the two solar cells 71b, 71c, which are the two ends in the series arrangement, the two electrodes 72a which connect to electrodes on opposite sides, respectively, are exposed and located along the inner edge of the substantially annular solar cells 71.

As shown in FIG. 2C, the lower electrode 713 of the solar cell 71c is directly connected to the electrode 72a on the lower electrode 713 (solar cell 71c). In other words, at the position where the lower electrode 713 overlaps the connection terminal 751 in plan view, the power generation layer 712 is removed. A connecting conductor such as conductive paste or conductive adhesive may be located between the lower electrode 713 and the electrode 72a. Alternatively, the electrode 72a may be referred to as the electrode 72a including the conductive paste. Furthermore, in this case, the electrode 72a may be only a connecting conductor that connects the lower electrode 713 to the outside. In other words, there is no need to have a separate electrode conductive layer above the lower electrode 713, in addition to the conductive paste or the like. The electrode 72a may be part of the lower electrode 713.

As shown in FIG. 3A, the wiring electrode 711 of the solar cell 71b is connected to the electrode 72a on the base 72 via a connecting wire 725 on the insulating surface (insulating layer 723) along the edge of the solar cell 71b.

These electrodes 72a are electrically connected to one ends (second ends) of extraction wirings 752 on the laminate film 75 (coat). The ends (first ends, ends opposite to the above second ends in the extraction wirings 752) opposite to the above second ends in the extraction wirings 752 are connected to extraction electrodes 753 located in a portion (first range) separated from the planar view range (second range) of the solar cell 71.

The power generation layer 712 includes a compound semiconductor material such as InGaP, for example, although it is not limited to any particular material. The lower electrode 713 is a planar electrode, but its planar view shape may not be identical to that of the power generation layer 712. The wiring electrode 711 and the lower electrode 713, which are adjacent to each other in plan view, are connected by a connection wiring 714 that connects, up and down, the gap (which may be an area on the lower electrode 713 where the power generation layer 712 and the wiring electrode 711 are not provided, intentionally) between the solar cells 71 each including the adjacent wiring electrode 711 and the lower electrode 713.

As shown in FIG. 2A and FIG. 3B, the base 72 and the laminate film 75 have portions protruding into the inner region surrounded by the solar cells 71 in addition to the top and bottom portions of the respective solar cells 71. On the surface (second face 75P) of the laminate film 75 attached to the solar cells 71, the connection terminals 751 with the solar cells 71, the extraction electrodes 753, and the extraction wirings 752 connecting the connection terminals 751 and the extraction electrodes 753 are located. The extraction electrodes 753 are located at one ends (second ends) of the extraction wirings 752. The extraction electrodes 753 are located in the above protruding portion of the laminate film 75, separated from the planar view range of the solar cell 71 (first range). As shown in FIG. 2C, the attached connection terminals 751 are located overlapping the electrodes 72a. The laminate film 75 is a member having light permeability in order not to inhibit power generation. In FIG. 2A and FIG. 3B, the wiring pattern (connection terminals 751, extraction wirings 752, and extraction electrodes 753) is shown as being visible on the back side through the laminate film 75. Through holes are located in the range overlapping the extraction electrodes 753 in the plan view of the base 72. The connection wiring, and the like to be connected to the circuit board of the electronic timepiece 1 are connected to the extraction electrodes 753 through the through holes.

The electrodes 72a (which may be/include a connecting conductor) and the connecting wire 725 constitute the connector of the present embodiment.

The laminate film 75 may have flexibility. Thereby, the laminate film 75 may warp along the base 72, and the like, and adhere or bond to the base 72, except where the connection terminals 751 are bonded to the electrodes 72a as shown in FIG. 2C. Furthermore, the laminate film 75 may have a concavo-convex structure that suppresses reflection of incidence light (moth-eye film) or the like. Alternatively, a further layer of such a film may be attached on top of the laminate film 75. The laminate film 75 also has an opening 755. This opening 755 corresponds to the position of the opening 54 where the date wheel 55 is exposed. There is also a gap between the solar cells 71b and 71c that is approximately the same size as the opening 755. Similarly, the base 72 has an opening corresponding to the position of the opening 54. This ensures that the date display by the date wheel 55 is properly displayed without being blocked by the solar cells 71.

As shown in FIG. 2B, the base 72 has an insulating layer 723 located on the support film 721 with an adhesive layer 722 in therebetween. The insulating layer 723 is bonded to the lower electrode 713 of the solar cell 71. The combination of the support film 721 and the insulating layer 723 can be determined according to, for example, the combination of adhesion and tracking properties with the solar cell 71 and the support strength. The connection terminals 751, the extraction wirings 752, and the extraction electrodes 753 (collectively, the wiring pattern) are formed, for example, by applying conductive paste on the laminate film 75. The conductive paste contains metal particles, for example, silver particles, and the like, and the metal particles are continuously bonded to each other to have conductivity.

The laminate film 75 is attached to the side of light incidence face (first face 71P) of the solar cells 71 as described above. If the laminate film 75 has a bonding/adhesive component on its surface, the laminate film 75 may be directly attached to the solar cells 71. However, in the embodiment, a conductive adhesive is applied to the connection terminals 751, and then the connection terminals 751 and the electrodes 72a are bonded via the conductive adhesive. This allows for a more secure and low-resistance electrical connection between the connection terminals 751 and the electrodes 72a. The conductive adhesive contains particles of, for example, silver or copper. Although not particularly limited, using same metal for the metal contained in the conductive adhesive and for the metal contained in the above conductive paste will more securely bond the connection terminals 751 and the electrodes 72a.

The manufacturing method of such solar panel 70 is as follows. (1) Form a wiring pattern (connection terminals 751, extraction wirings 752, and extraction electrodes 753) by conductive paste on the laminate film 75 of a designed shape (FIG. 3B). Formation of the wiring pattern by the conductive paste may be performed by any known and appropriate method, such as printing.

(2) Apply conductive adhesive, at the location of electrodes 72a, to the structure 700 (FIG. 3A) having the solar cells 71 and the base 72 cut from the wafer. The conductive adhesive may be applied to the connection terminals 751 of the laminate film 75.

(3) Align the relative positions of the structure 700 and the laminate film 75 to make contact and attach (bond) the laminate film 75 (connection terminals 751) to the structure 700 (electrodes 72a) using the conductive adhesive so that the wiring pattern is electrically connected to the electrode of the solar cell 71 (FIG. 2A).

### (Second Embodiment)

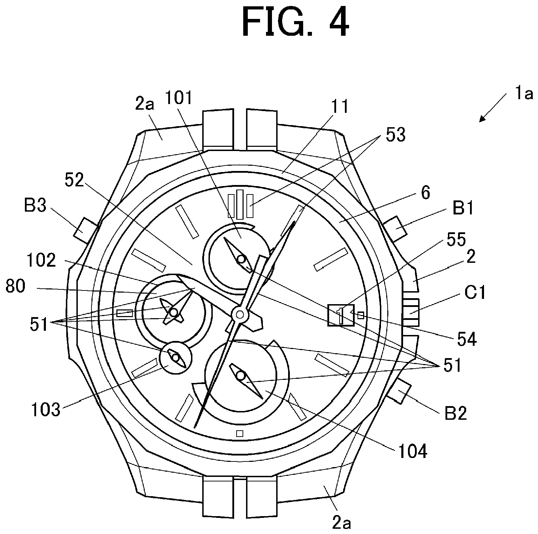

FIG. 4 is a plan view of an electronic timepiece 1a of a second embodiment.

The electronic timepiece 1a, which is the electronic device of the present embodiment, differs from the electronic timepiece 1 in the location of the small windows 101 to 104 and the opening 54. A solar panel 80 is located inside the small window 102 in plan view. The portion of the dial 52 other than the small window 102 may not be permeable to light. The date wheel 55 has each date sign facing in an orientation consistent with the position of the opening 54. The other configurations are same between both embodiments, and same configurations are marked with the same reference numerals and the like, and omitted from the description.

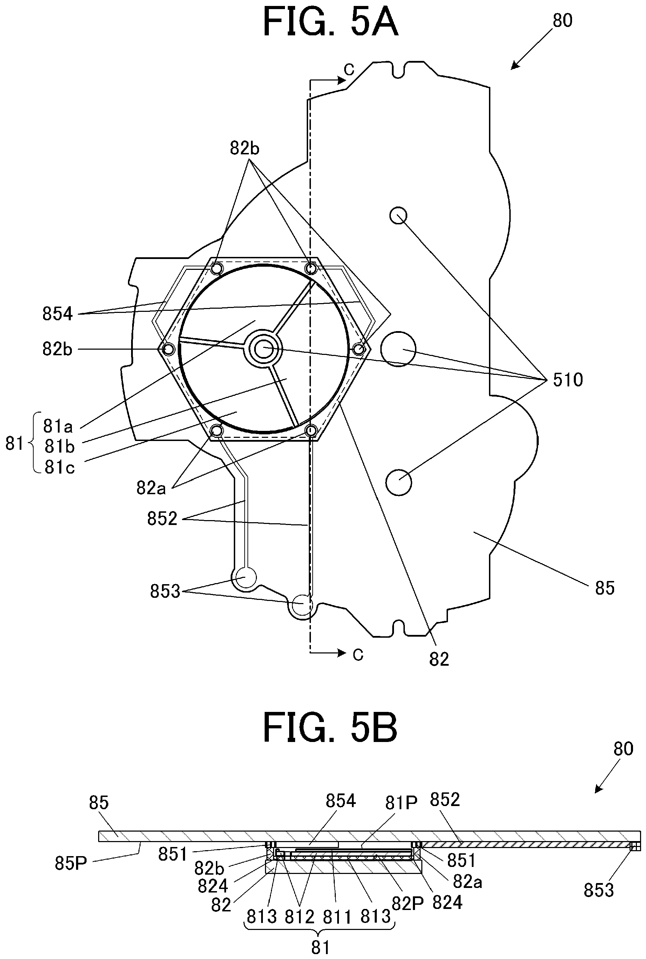

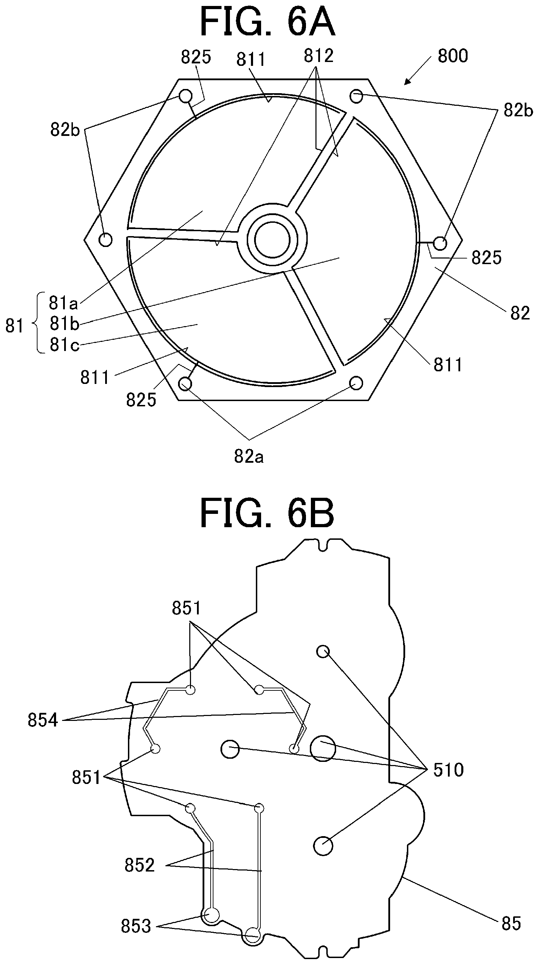

FIG. 5A, FIG. 5B, FIG. 6A and FIG. 6B illustrate the solar panel 80.

FIG. 5A is a plan view explaining the panel arrangement of the solar panel 80. FIG. 5B is a view showing a cross-sectional structure along the cross-sectional line CC of FIG. 5A. FIG. 6A is a plan view of solar cells 81 and a base 82. FIG. 6B is a plan view of a laminate film 85.

The solar panel 80 includes a structure 800 having a base 82 and a plurality of, for example, three solar cells 81a to 81c (also collectively described as solar cells 81) located on one side (third face 82P) of the base 82, and a laminate film 85. As shown in FIG. 5A and FIG. 6A, the solar cells 81a to 81c each have a fan shape. They are arranged in a circular shape as a whole, with the center position of the fan shape being approximately the same. This circular-shaped range generally corresponds to the display surface of the small window 102 (range of rotation of the hands 51 (small hands) rotating within the small window 102), but they need not be the same size. The solar cells 81a to 81c do not necessarily have to be the same shape. The angular width of each may be different from each other. The solar cell 81 has a lower electrode 813, a power generation layer 812, and a wiring electrode 811 overlapping in this order, as in the solar cell 71 of the first embodiment. As shown in FIG. 6A, the wiring electrode 811 extends along the plan view outer edge of each of the solar cells 81a to 81c.

The base 82 has a regular hexagonal shape (polygonal shape) that encompasses the above circular range. Near each vertex of the regular hexagon outside of the solar cells 81 in plan view, a total of six electrodes 82a, 82b are located, which are connected to both poles of the three solar cells 81a to 81c. The structure of the base 82 may be the same as the base 72 of the first embodiment above and will not be described.

On the side of the light incidence surface (first face 81P) to the solar cells 81, a laminate film 85 (coat) is attached as shown in FIG. 5A, FIG. 5B and FIG. 6B. On the surface (second face 85P) of the laminate film 85 to be attached to the above first face 81P, extraction electrodes 853, extraction wirings 852 with one ends (second ends) leading to the extraction electrodes 853, and connection wirings 854 connecting the solar cells 81a to 81c in series are located.

The laminate film 85 is larger than the base 82, the solar cells 81 and the small window 102, and through holes 510 (holes) through which the rotation axes of the hands 51 pass are located at the positions of the rotation axes of the hands 51. Thus, the laminate film 85 is aligned. The laminate film 85 also has cutouts at the edge, and a screw or the like is inserted into the cutouts to align the film 85. The laminate film 85, for example, covers the entire base 82 and solar cells 81. At least the portion overlapping the solar cells 81 (power generation layer 812) in plan view (second range) of the laminate film 85 has light permeability. Alternatively, the laminate film 85 may not cover the entire surface of the base 82 and solar cells 81. The laminate film 85 may not have light permeability in the portion that does not overlap the solar cells 81 in plan view.

As described above, the solar cells 81a to 81c are connected in series. In the two solar cells 81b, 81c which are both ends in the series arrangement, the two electrodes 82a connected to the electrodes on the opposite side are electrically connected to the extraction wirings 852 of the laminate film 85. One ends of the extraction wirings 852 (first ends, the ends opposite to the second ends above) are connected to the extraction electrodes 853 located at a portion (first range) separated from the planar view range (second range) of the solar cells 81. The remaining four electrodes 82b are connected to the solar cells 81a to 81c in series by the connection wirings 854. The extraction wirings 852, the extraction electrodes 853 (first ends) and the connection wirings 854 do not overlap the solar cells 81 (power generation layers 812) in plan view. As a result, the extraction wirings 852 and the connection wirings 854 do not obstruct the incidence light to the solar cells 81. The three lower electrodes 813 are connected to one of the electrodes 82a (solar cell 81b) and two of the electrodes 82b (solar cells 81a, 81c) on the base 82 by the connecting conductor 824 in FIG. 5B.

As shown in FIG. 6B, the connection terminals 851 are located at the positions overlapping the electrodes 82a, 82b when the laminate film 85 is viewed in plan view. The positions of the connection terminals 851 are equal to the positions of the second ends of the extraction wirings 852 and both ends of the connection wirings 854. The wiring pattern including the connection wirings 854 in addition to the connection terminals 851, the extraction wirings 852 and the extraction electrodes 853 can be formed by applying conductive paste on the laminate film 85 in the same manner as the wiring pattern of the first embodiment.

The extraction electrodes 853 at the tips of the extraction wirings 852 located on the second face 85P of the laminate film 85 attached to the first face 81P and the like of the solar cells 81 are facing downward. Since the laminate film 85 is larger than the base 82 and there is no base 82 in the position of overlapping the extraction electrodes 853 in plan view, the extraction electrodes 853 are exposed toward the interior of the electronic timepiece 1a. Therefore, the extraction electrodes 853 can be easily connected to the substrate (circuit board) and other components of the electronic timepiece 1a. For the solar cells 81 on the base 82, if the extraction electrodes are to be oriented in the opposite direction (downward) from the direction of light incidence (upward), further work will be required, such as providing a through hole in the base 82. However, by forming the extraction wirings 852 and the extraction electrodes 853 separately on the laminate film 85 and then simply attaching them to the structure 800, which consists of the base 82 and the solar cells 81, fabrication is easy.

Since the extraction wirings 852 and the extraction electrodes 853 are located on the laminate film 85, even if the above structure 800 has a generic shape and electrode arrangement, the wiring can be easily drawn out to any position according to the internal structure of the electronic timepiece 1a.

Furthermore, since the above structure 800 is a general-purpose shape and stays within the range required to obtain the solar cells 81, it is easier to obtain more structures 800 from a single wafer.

The wiring electrode 811 on the side of light incidence surface (first face 81P) in the solar cell 81 has a thin line shape so as not to interfere with the incidence of light into the power generation layer 812. In FIG. 6A, the wiring electrode 811 is described along the edge of the power generation layer 812, but is not limited to this. The wiring electrode 811 may be across the interior of the power generation layer 812 in plan view. The wiring electrode 811 is not limited to a circular arc shape. The wiring electrode 811 may be arbitrarily bent or curved. As shown in FIG. 6A, the three wiring electrodes 811 are connected to one of the electrodes 82a (solar cell 81c) and two of the electrodes 82b (solar cells 81a, 81b) on the base 82 by the connecting wires 825. The electrodes 82a, 82b may be extended to the wiring electrode 811 side and directly connected to the wiring electrode 811.

The electrode 82a, connecting conductor 824, and the connecting wires 825 constitute the connector of the present embodiment.

As shown in FIG. 5B, the electrodes 82a, 82b on the base 82 have a thicker structure than the solar cells 81. Therefore, the connection between the electrodes 82a, 82b and the connection terminals 851 is easily made by conductive adhesive or other means.

As described above, the electronic timepieces 1, 1a of the present embodiments include: the solar cells 71, 81 having power generation layers 712, 812 and the wiring electrodes 711, 811 and the lower electrodes 713, 813 as pairs of electrodes, which sandwich the power generation layers 712, 812; and the laminate films 75, 85 that are attached to at least part of the first faces 71P, 81P of the solar cells 71, 81. The laminate films 75, 85 have extraction wirings 752, 852 located on the second faces 75P, 85P, which are attached to the first faces 71P, 81P of the solar cells 71, 81 and are electrically connected to the above pairs of electrodes, respectively. Conventionally, the structures of solar cells tend to be custom-made according to the shape and size of electronic timepieces. Therefore, the solar cells mounted on the electronic timepieces have the problem of increased time and cost involved in design development and manufacturing, respectively. In contrast, according to the electronic timepieces 1, 1a, the extraction wirings 752, 852 can be flexibly formed on the laminate films 75, 85 according to the structure of individual electronic timepieces 1, 1a. Therefore, the structures of the solar cells 71, 81 themselves can be easily used together in a plurality of electronic timepieces. Thus, the electronic timepieces 1, 1a can more easily and flexibly output the power generated by the solar cells 71, 81 to a circuit board, and the like.

One ends of the extraction wirings 752, 852 (the ends of the connection with the extraction electrodes 753, 853) may be located in the first range that do not overlap the solar cells 71, 81 in plan view. Thus, the electronic timepieces 1,1a can form extraction wirings without difficulty and more easily connect the solar cells 71, 81 to the internal circuit boards and other components.

The electronic timepieces 1, 1a may also have the electrodes 72a, 82a, the connecting conductors 824 and the connecting wires 725, 825 outside the power generation layers 712, 812 in plan view of the first faces 71P, 81P of the solar cells 71, 81, the electrodes 72a, 82a, being drawn out respectively via the connecting conductors 824 and the connecting wires 725, 825, and the like as required from the pairs of electrodes (wiring electrodes 711, 811 and lower electrodes 713, 813) and are bonded to the connection terminals 751, 851 located at the second ends opposite to the first ends of the extraction wirings 752, 852. By having the connection ends with the extraction wirings 752, 852 located off the solar cells 71, 81, the electronic timepiece 1, 1a is easier to ensure a secure connection with the solar cells 71, 81.

The extraction wirings 752, 852 may not overlap the power generation layers 712, 812 in plan view. In other words, the extraction wirings 752, 852 themselves do not affect power generation and can be appropriately designed and arranged to convey the power drawn out through the electrodes 72a, 82a.

The first faces 71P, 81P of the solar cells 71, 81 may be the incidence surfaces of light to the power generation layers 712, 812. Therefore, the extraction wirings 752, 852 almost do not interfere with power generation, so that the decrease in power generation efficiency is sufficiently suppressed. When the light incidence surface faces the outside of the electronic timepiece 1, the second faces 75P, 85P of the laminate films 75, 85 facing the first faces 71P, 81P face the inside of the electronic timepiece 1. Therefore, it is possible to easily connect the extraction electrodes 753, 853 on the second faces 75P, 85P to a circuit board or the like inside the electronic timepiece 1. By attaching the laminate films 75, 85 to the first faces 71P, 81P, such a positional relationship can be easily obtained.

The laminate films 75, 85 may have the second range overlapping the power generation layers 712, 812 in plan view, and at least the second range may have light permeability. In other words, the laminate films 75, 85 may be used as protective films for the power generation layers 712, 812. Since the laminate films 75, 85 have light permeability, it is possible to appropriately protect the power generation layers 712, 812 without affecting power generation, and can suppress a decrease in power generation efficiency, and the like due to deterioration, damage, and the like.

The electronic timepieces 1, 1a may have a plurality of solar cells 71, 81. The laminate film 85 may have connection wiring(s) 854 located on the second face 85P and connecting the plurality of solar cells 81 in series. In cases where the power generation voltage is insufficient with a single solar cell 71, 81 even when there is a sufficient amount of incoming light due to the configuration of the solar cell 71, 81, the internal operating voltage, and the like, the appropriate voltage can be obtained without using a voltage booster circuit by connecting the plurality of solar cells 71, 81 in series. This simplifies the structure of solar panels 70, 80. In addition, by forming the connection wiring(s) 854 on the surface of the laminate film 85, complex wiring is not required in the structure 800 of the solar cells 81 and the base 82. Thus, the versatility of this structure 800 is further enhanced.

The laminate films 75, 85 may have flexibility. This facilitates handling of the laminate films 75, 85 during attachment while aligning them. In addition, the laminate films 75, 85 can be positioned along the uneven top surfaces of the structures 700, 800 to protect the solar cells 71, 81, and the like.

The above structures 700, 800 may include the bases 72, 82 having the third faces 72P, 82P on which the plurality of solar cells 71, 81 are located. The plurality of solar cells 81 may each have a fan shape and may be arranged in a circular shape as a whole on the base 82 in plan view. The base 82 may have a polygonal shape that encompasses the range of the circular shape in plan view.

The structures 700, 800 are supported by the bases 72, 82, which are slightly larger than the solar cells 71, 81. Thus, the semiconductor process can be used to obtain the structures 700, 800 containing the solar cells 71, 81 with high precision. In addition, the manufacturing efficiency is improved since cutting in polygonal shapes is easy and a plurality of pieces can be obtained by efficiently arranging them on a single wafer.

The electronic timepieces 1, 1a also include the hands 51 that are rotatable. The hands 51 include small hands that rotate only on part of the display surface, and the plurality of solar cells 81 are located in the small window 102, which is the range corresponding to the range of rotation of the small hands. In this way, in an electronic timepiece 1 with small windows (sub-dials) on the dial, limiting the solar panel 70 to within a specific small window makes it less susceptible to design restrictions, and the like, according to the boundaries of that range, and allows for more diverse dial designs for the electronic timepiece 1.

The laminate film 85 may have the through holes 510 through which the rotation axes of the hands 51 pass. The laminate film 85 being larger in size than the solar cells 81 makes it easier to define a plurality of portions where the fixing position is properly defined. This allows for more appropriate reduction of misalignment during manufacture of the solar panels 70, 80, thereby suppressing yield reduction and the like.

The manufacturing method of the solar panels 70, 80 of the embodiments also includes the following steps. (1) The step of forming wiring patterns (connection terminals 751, 851, extraction wiring 752, 852, and extraction electrodes 753, 853) on the laminate films 75, 85. (2) The step of attaching the laminate films 75, 85 to the structures 700, 800 of the solar cells 71, 81 having the power generation layers 712, 812 and the pairs of electrodes (wiring electrodes 711, 811 and lower electrodes 713, 813) that sandwich the power generation layers 712, 812, so that the above wiring patterns are electrically connected to the above pairs of electrodes.

Thus, it is easier than in the past to form the wiring patterns for outputting electric power to circuit boards, such as control and drive units, on the laminate films 75, 85 separately from the solar cells 71, 81 and the bases 72, 82. In addition, by attaching the laminate films 75, 85 to the structures 700, 800 after forming such wiring patterns, it is possible to attach the laminate films 75, 85 having a variety of wiring patterns. Therefore, the electromotive force of the solar cells 71, 81, and the like can be easily supplied to the outside without having to redesign the structure of solar cells 71, 81, and the like each time for each electronic timepiece product, and the like. Therefore, the electronic timepieces 1 and 1a using the solar panels 70, 80 thus obtained can reduce the time and effort required for development and design, as well as manufacturing costs.

The above structure 800 may also include the base 82. The solar cells 71, 81 may be located on the bases 72, 82. The electrodes 72a, 82a respectively leading to the above pairs of electrodes may be located on at least one of the bases 72, 82 or the solar cells 71, 81. The wiring patterns may include the extraction wirings 752, 852 that are drawn out from the pairs of electrodes to the outside. In attaching the laminate films 75, 85, one ends (connection terminals 751, 851) of the extraction wirings 752, 852 are bonded to the electrodes 72a, 82a using conductive adhesive. Thus, the solar cells 71, 81 can be easily obtained reliably and with high yield by the semiconductor process. As a result, the solar panels 70, 80 can electrically connect the solar cells 71, 81 to the laminate films 75, 85 with low resistance and reliability.

The wiring patterns may be formed by conductive paste. The wiring patterns on the laminate films 75, 85 can be obtained flexibly and appropriately.

The above embodiments are examples, and various changes are possible. For example, in the above embodiments, the laminate films 75, 85 are used as examples of the coat, but the coat is not limited to them. The coat may be a general resin film or resin plate that is not considered a laminate film. The coat may be made of different materials for the portion with light permeability covering the power generation layers 712, 812 and other portions. The portions of different materials may each be separately attached to the structures 700, 800.

The shape and positioning of the plurality of solar cells 71, 81 are not limited to the examples shown above. The plurality of solar cells 81 may be dispersed in a plurality of small windows. In this case, there may be used a common laminate film 85 with connection wirings 854 that connect the solar cells 81 in series within the plurality of small windows. Alternatively, the extraction wirings 852 that output the generated electromotive force obtained by connecting in series within the individual small windows may be connected in parallel. In this case, the circuit is defined in such a way that no reverse current is generated when the output voltage differs between the extraction wirings 752. The shape of the base 72 is also not limited to the above.

The connection wirings 854 may be located on the base 82, and the connection wirings 714 may be located on the laminate film 75.

In the second embodiment above, the laminate film 85 with the through holes 510 through which the rotation axes of the hands 51 pass was described, but the position may be aligned by holes or notches corresponding to other pins, and the like.

The plurality of wiring electrodes 711, 811 may extend in parallel.

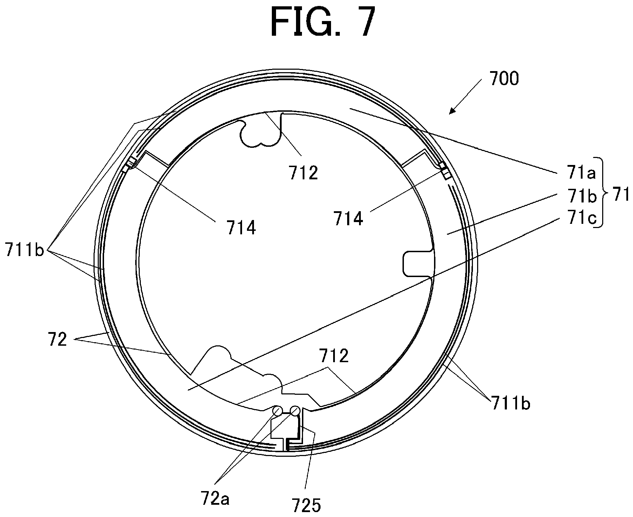

FIG. 7 is another example of the structure 700 of the solar panel 70 of the first embodiment.

The wiring electrodes 711b may be two parallel wires. By having a plurality of wiring electrodes 711b in this manner, the solar cells 71 can continue to generate power even if any one of the wiring electrodes 711b is cut off.

In the above embodiments, the display screen having small windows and small hands that rotate inside the small windows is described, but is not limited to this. The hands 51 may only be those that rotate around a common rotation axis located at the approximate center of the dial 52. The dial 52 may also include a digital display screen in addition to or instead of the display by the hands 51.

The wiring pattern may be formed not by a paste, but by a liquid or sol-like substance that hardens under specific conditions.

The laminate films 75, 85 are described as being bonded to the connection terminals 751, 851 and the electrodes 72a, 82a by a conductive adhesive, but this does not preclude other parts from being further bonded. The laminate films 75, 85 may be bonded to the bases 72, 82, and the like by ordinary insulating adhesives at positions that do not affect power generation or conduction.

The electronic device may be other than an electronic timepiece. For example, the contents of the present disclosure may be used for electronic devices that vary in shape and size according to the model of the product, and the like. In addition, the contents of the present disclosure may be used flexibly according to the design, such as the number and position of the hands, especially in an electronic device having moving parts such as hands and a drive unit such as a motor to operate the moving parts.

Other specific configurations, contents and procedures of processing operations, and the like shown in the above embodiments can be changed as appropriate in the range not departing from the gist of the present disclosure. The scope of the present disclosure includes the scope of inventions, which is described in the scope of claims, and the scope equivalent thereof.

## Claims

1. An electronic device (1) comprising:
a solar cell (71) including a power generation layer (712) and a pair of electrodes (711, 713) that sandwich the power generation layer; and
a coat (75) that has a second face (75P) attached to at least part of a first face (71P) of the solar cell, wherein
the coat includes extraction wirings (752) that are located on the second face and electrically connected to the electrodes.

2. The electronic device according to claim 1, wherein first ends of the extraction wirings are located in a first range that does not overlap the solar cell in plan view.

3. The electronic device according to claim 2, further comprising connectors (72a, 725) that are located outside the power generation layer in plan view of the first face and drawn out from the respective electrodes to be bonded to second ends of the extraction wirings opposite to the first ends.

4. The electronic device according to claim 3, wherein the extraction wirings do not overlap the power generation layer in plan view.

5. The electronic device according to any one of claims 1 to 4, wherein the first face is an incidence surface of light to the power generation layer.

6. The electronic device according to claim 5, wherein
the coat has a second range that overlaps the power generation layer in plan view, and
at least the second range has light permeability.

7. The electronic device according to claim 5, wherein the coat has flexibility.

8. The electronic device according to any one of claims 1 to 7, comprising a plurality of solar cells, each of the solar cells being the solar cell, wherein
the coat includes a connection wiring (854) that is located on the second face and connects the plurality of solar cells in series.

9. The electronic device according to claim 8, further comprising a base (72) that has a third face (72P) on which the plurality of solar cells are located, wherein
the plurality of solar cells respectively have fan shapes and are arranged in a circular shape as a whole on the base in plan view, and
the base has a polygonal shape that encompasses a range of the circular shape in plan view.

10. The electronic device according to claim 9, further comprising a hand (51) that is rotatable, wherein
the hand includes a small hand that rotates only on part of a display surface, and
the plurality of solar cells are located in a range corresponding to a range of rotation of the small hand.

11. The electronic device according to any one of claims 1 to 10, further comprising a hand that is rotatable, wherein
the coat includes a through hole (510) through which a rotation axis of the hand passes.

12. An electronic timepiece comprising:
a solar cell (71) including a power generation layer (712) and a pair of electrodes (711, 713) that sandwich the power generation layer; and
a coat (75) that has a second face (75P) attached to at least part of a first face (71P) of the solar cell, wherein
the coat includes extraction wirings (752) that are located on the second face and electrically connected to the electrodes.

13. A manufacturing method of a solar panel, the method comprising:
forming a wiring pattern on a coat; and
attaching the coat to a structure of a solar cell including a power generation layer and a pair of electrodes that sandwich the power generation layer, so that the wiring pattern is electrically connected to the pair of electrodes.

14. The manufacturing method according to claim 13, wherein
the structure includes a base,
the solar cell is located on the base,
electrodes (72a) respectively leading to the pair of electrodes are located on at least one of the base or the solar cell, and
the wiring pattern includes extraction wirings that are drawn out to an outside from the pair of electrodes, and in the attaching of the coat, one ends of the extraction wirings are bonded to the electrodes by conductive adhesive.

15. The manufacturing method according to claim 13 or 14, wherein the wiring pattern is formed by conductive paste.
